# FASCICULE DE BREVET EUROPEEN

(11) **EP 3 678 151 B1**
(45) Date de publication et mention de la délivrance du brevet: **15.11.2023**
(21) Numéro de dépôt: 20150041.0
(22) Date de dépôt: 02.01.2020
(51) Int. Cl.: H01F 17/00, H02M 1/14

(54) **FILTRE INDUCTIF POLYPHASÉ**
MEHRPHASIGER INDUKTIVER FILTER
POLYPHASE INDUCTIVE FILTER

(30) Priorité: 04.01.2019 FR 1900095
(43) Date de publication de la demande: 08.07.2020
(73) Titulaire: Commissariat à l'Energie Atomique et aux Energies Alternatives, 75015 Paris (FR)
(72) Inventeur: LEFEVRE, Guillaume, 38054 GRENOBLE CEDEX 9 (FR)
(74) Mandataire: Cabinet Beaumont

(56) Documents cités:
- EP-A- 0 028 971
- US-A1- 2009 273 428
- KROICS KASPARS ET AL: "Digitally controlled 4-phase interleaved DC-DC converter with coupled inductors for storage application in microgrid", 2015 9TH INTERNATIONAL CONFERENCE ON COMPATIBILITY AND POWER ELECTRONICS (CPE), IEEE, 24 juin 2015 (2015-06-24), pages 504-509, XP033214370, DOI: 10.1109/CPE.2015.7231127
- PAN TENGTENG ET AL: "Research on high power interleaved bidirectional dc/dc converter with coupling technique", 2017 IEEE TRANSPORTATION ELECTRIFICATION CONFERENCE AND EXPO, ASIA-PACIFIC (ITEC ASIA-PACIFIC), IEEE, 7 août 2017 (2017-08-07), pages 1-6, XP033237014, DOI: 10.1109/ITEC-AP.2017.8080875

## Description

### Domaine technique

La présente description concerne un dispositif pour un convertisseur à découpage comprenant un filtre polyphasé, comportant au moins deux transformateurs, dans lequel chaque enroulement d'un transformateur est électriquement en série avec un enroulement d'un autre transformateur.

### Technique antérieure

Un convertisseur permet de fournir, à partir d'énergie produite par une source, des niveaux de courant et/ou de tension compatibles avec une application. Un tel convertisseur est souvent de type à découpage, c'est-à-dire dans lequel on répète des ouvertures et fermetures alternatives d'interrupteurs. Les durées d'ouverture et de fermeture sont commandées afin de réguler la tension et/ou le courant produits par le convertisseur. Des éléments inductifs permettent de limiter les variations de courant et/ou de tension produites par ces ouvertures et fermetures répétées.

Le document XP33214370 décrit un convertisseur continu-continu entrelacé polyphasé, commandé numériquement et à inductance couplées.

Le document XP033237014 décrit un convertisseur continu-continu bidirectionnel entrelacé basé sur une technique de couplage.

### Résumé de l'invention

Un mode de réalisation pallie tout ou partie des inconvénients des convertisseurs connus.

Un mode de réalisation pallie tout ou partie des inconvénients des éléments inductifs connus.

Un mode de réalisation prévoit un dispositif tel que défini dans les revendications

Un mode de réalisation prévoit un filtre inductif polyphasé tel que revendiqué.

Un mode de réalisation prévoit un convertisseur à découpage tel que revendiqué.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente de manière schématique un exemple de convertisseur auquel s'appliquent les modes de réalisation décrits ;
la figure 2 représente de manière schématique un mode de réalisation d'un filtre inductif ;
la figure 3 représente de manière schématique un autre mode de réalisation d'un filtre inductif ;
la figure 4 représente de manière schématique un autre mode de réalisation d'un filtre inductif ; et
la figure 5 représente une vue en coupe et en perspective d'un mode de réalisation d'un transformateur d'un filtre inductif.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

Divers exemples de mise en œuvre et de réalisation sont exposés par la suite. Indépendamment de la dénomination donnée à ces exemples (modes de réalisation, exemple, variante, etc.) et les qualificatifs employés (par exemple, de préférence, etc.), seules les parties de description incluent dans la portée des revendications font partie de la présente invention, les autres exemples n'étant utiles que pour mettre en évidence des aspects spécifiques à l'invention par rapport à ce qui n'en fait pas partie.

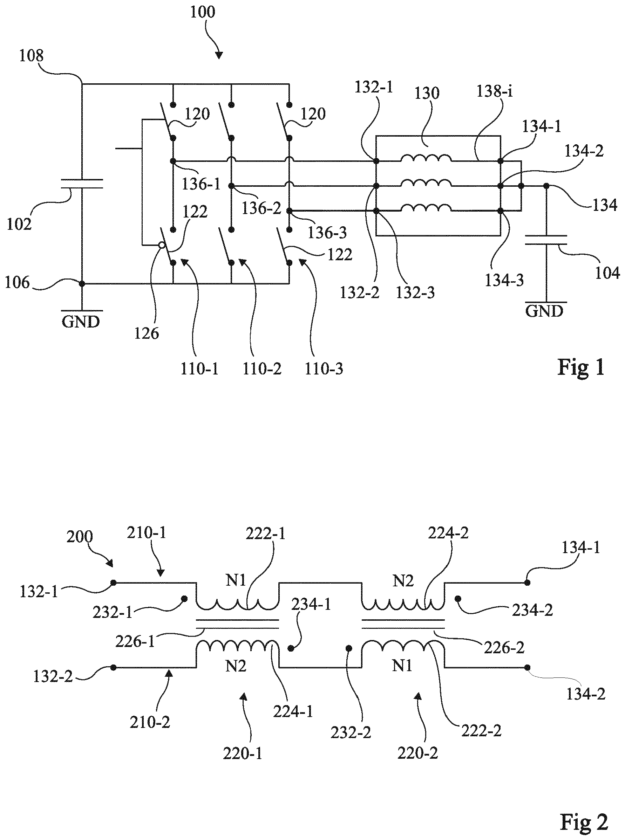

La figure 1 représente de manière schématique un exemple de convertisseur 100 auquel s'appliquent les modes de réalisation décrits.

Dans cet exemple, le convertisseur 100 est un abaisseur de tension. Le convertisseur 100 comprend une capacité d'entrée 102 et une capacité de sortie 104. La capacité 102 est connectée entre 2 noeuds d'entrée 106 et 108 du convertisseur 100, qui reçoivent de l'énergie électrique à partir d'une source non représentée. Dans cet exemple, le noeud 106 est un noeud d'application d'un potentiel de référence, tel que la masse GND. La capacité 104 est connectée en parallèle d'une charge non représentée.

Le convertisseur comprend plusieurs branches 110_i en parallèle entre les noeuds 106 et 108, où l'indice i est un entier compris entre 1 et N. Dans l'exemple représenté, le nombre N est égal à 3, et le convertisseur 100 comprend donc trois branches 110_1, 110_2, et 110_3. Chaque branche comprend deux interrupteurs 120 et 122 électriquement reliés en série, de préférence connectés en série. Les interrupteurs 120 et 122 comprennent par exemple chacun un ou plusieurs transistors.

Dans chaque branche 110_i, les interrupteurs 120 et 122 sont commandés de façon à éviter une conduction simultanée des deux interrupteurs de la branche. De façon schématique et simplifiée, les deux interrupteurs d'une même branche reçoivent des signaux de commande complémentaires. En fonctionnement, l'interrupteur 120 est ouvert lorsque l'interrupteur 122 est fermé, et l'interrupteur 122 est ouvert lorsque l'interrupteur 122 est fermé. Ceci est par exemple obtenu en utilisant des transistors de même type et en inversant la commande, par exemple par un inverseur 126, pour un seul des interrupteurs 120 et 122. En variante, l'interrupteur 122 de chaque branche, situé du côté de la masse, est une diode, et son ouverture et sa fermeture sont obtenues sans commande active.

Dans chaque branche 110_i, les interrupteurs 120 et 122 sont commandés en modulation de largeur d'impulsion ("Pulse Width Modulation, PWM"), c'est-à-dire que l'on répète pour chaque interrupteur des ouvertures et des fermetures à une fréquence donnée dite fréquence de découpage, ou en PFM ("Pulse Frequency Modulation"), c'est-à-dire en faisant varier la fréquence de découpage.

Les branches 110_i sont commandées à la même fréquence de découpage. Les commandes des branches 110_i sont typiquement des commandes entrelacées, c'est-à-dire déphasées les unes par rapport aux autres. De préférence, les déphasages entre les branches sont régulièrement répartis entre 0 et 360 degrés.

Le convertisseur 100 comprend un filtre inductif 130 reliant les branches 110_i à la capacité de sortie 104. Le filtre inductif 130 présente des noeuds, ou bornes, 132_i (132_1, 132_2, 132_3, côté gauche), et des noeuds, ou bornes, 134_i (134_1, 134_2, 134_3, côté droit). Les noeuds 132_i sont connectés respectivement aux branches 110_i. Plus précisément, les branches 110_i ont chacune un noeud milieu 136_i (136_1, 136_2, 136_3) qui connecte entre eux les interrupteurs 120 et 122, et les noeuds 136_i sont reliés, de préférence connectés, respectivement aux noeuds 132_i. Les noeuds 134_i sont reliés entre eux à une électrode 134 de la capacité 104. L'autre électrode de la capacité 104 est reliée par exemple à la masse GND.

Le filtre 130 comprend des liaisons 138_i, ou voies, reliant les noeuds 132_i respectivement aux noeuds 134_i. Dans l'exemple représenté, le filtre 130 est triphasé, c'est-à-dire un filtre à trois voies. Les liaisons 138_i sont inductives et de préférence électriquement isolées entre elles.

En fonctionnement, le filtre polyphasé 130 permet d'amortir les variations de courant dans chaque voie. Les noeuds 136_i fournissent alors des valeurs alternatives de potentiel présentant entre elles des déphasages uniformément répartis entre 0 et 360 degrés, appelées phases d'une tension alternative polyphasée.

Les filtres inductifs polyphasés sont aussi utilisés dans d'autres types de convertisseur que celui présenté ci-dessus. Par exemple, la capacité 104 peut recevoir de l'énergie à partir d'une source, et la capacité 102 peut être connectée en parallèle d'une charge. Le convertisseur est alors de type élévateur de tension. Le filtre 130 permet de limiter le courant circulant entre la capacité 104 et la charge commutée constituée par les branches 110_i et la capacité 102.

L'utilisation de filtres inductifs polyphasés n'est pas limitée aux convertisseurs ci-dessus. En particulier, on peut remplacer les branches du convertisseur par toute source fournissant, sur les noeuds 132_i, des tensions alternatives présentant entre elles des déphasages. La capacité de sortie 104 peut être remplacée par exemple par plusieurs charges capacitives reliées respectivement aux noeuds 134_i.

Par exemple, dans certaines applications, on utilise plusieurs convertisseurs produisant et/ou recevant des tensions alternatives à une fréquence inférieure aux fréquences de découpage des convertisseurs. On peut alors utiliser un ou plusieurs filtres inductifs entre ces convertisseurs et une ou des charges recevant les tensions alternatives fournies par les convertisseurs. On peut également utiliser un ou plusieurs filtres inductifs entre les convertisseurs et une des sources alimentant les convertisseurs.

La figure 2 représente schématiquement un mode de réalisation d'un filtre inductif 200. Dans ce mode de réalisation, le filtre inductif a deux voies 210_1 et 210_2. Le filtre inductif 200 peut être utilisé à la place du filtre 130 d'un convertisseur à deux branches du type de celui décrit en relation avec la figure 1. La voie 210_1 relie entre eux des noeuds, ou bornes, 132_1 et 134_1, et la voie 210_2 relie entre eux des noeuds, ou bornes, 132_2 et 134_2.

Le filtre 200 comprend un transformateur 220_1, comprenant des enroulements 222_1 et 224_1, et un transformateur 220_2 comprenant des enroulements 222_2 et 224_2. Dans chaque transformateur 220_1, 220_2, les deux enroulements sont couplés magnétiquement l'un à l'autre par des circuits magnétiques respectifs 226_1 et 226_2. La voie 210_1 comprend deux enroulements 222_1 et 224_2 électriquement en série appartenant chacun à l'un des transformateurs 220_l et 220_2. L'enroulement 222_1 est par exemple du côté du noeud 132_1. La voie 210_2 comprend deux enroulements 224_1 et 222_2 électriquement en série appartenant chacun à l'un des transformateurs 220_l et 220_2. L'enroulement 224_1 est par exemple du côté du noeud 132_2. Ainsi, chaque transformateur comprend un enroulement de la voie 210_1, et un enroulement de la voie 210_2. Chaque enroulement d'un transformateur est électriquement en série avec un enroulement de l'autre transformateur.

Les transformateurs 220_l et 220_2 couplent ainsi magnétiquement les voies 210_1 et 210_2. Ce couplage magnétique, ou couplage mutuel, permet, par exemple dans le cas d'un convertisseur à deux branches, au filtre 200 de réduire l'amplitude des variations du courant circulant dans les interrupteurs du convertisseur, par rapport à un filtre dans lequel chaque voie présenterait une inductance non couplée aux inductances des autres voies.

Les transformateurs 220_l et 220_2 ont des rapports de transformation différents de 1, par exemple à 5 % près, de préférence à 10 % près. Dans chaque transformateur 220_1, 220_2, le rapport de transformation entre l'enroulement 222_1, 222_2 et l'enroulement 224_1, 224_2 est défini par le rapport entre le nombre de tours, ou spires, de l'enroulement 224_1, 224_2, et le nombre de spires de l'enroulement 222_1, 222_2.

Du fait que les rapports de transformation sont différents de 1, les voies 210_1 et 210_2 sont moins couplées magnétiquement que si les rapports de transformation étaient égaux à 1. On évite alors le risque que le couplage magnétique soit trop fort entre les voies. En effet, un couplage trop fort ferait perdre l'avantage sur les variations de courant du couplage magnétique entre les voies. En limitant le couplage magnétique, par exemple à un coefficient de couplage magnétique entre les voies compris entre 0,5 et 0,9, par exemple inférieur à 0,8, on bénéficie du filtrage des variations de courant dû au couplage magnétique entre les voies. En particulier, on choisit les rapports de transformation en sorte d'obtenir une amplitude minimale des variations de courant, par exemple lorsque le filtre est utilisé dans un convertisseur à deux branches du type décrit en relation de la figure 1. Pour cela, les rapports de transformation sont par exemple supérieurs à 2 ou inférieurs à 0,5, de préférence supérieurs à 3 ou inférieurs à 1/3, préférentiellement supérieurs à 5 ou inférieurs à 1/5. On obtient ainsi une valeur optimale du couplage entre les voies. De préférence, on définit, dans chaque transformateur, un enroulement primaire et un enroulement secondaire. Par exemple, les enroulements primaires sont les enroulements 222_1 et 222_2 situés dans des voies distinctes. Les rapports de transformation sont alors définis entre l'enroulement primaire et l'enroulement secondaire, et sont de préférence inférieurs à 1.

De préférence, le rapport de transformation entre l'enroulement 222_1 et l'enroulement 224_1 est le même que le rapport de transformation entre l'enroulement 222_2 et l'enroulement 224_2. Les inductances présentées par les voies 210_1 et 210_2 sont alors égales. On obtient, par exemple dans le cas d'une utilisation du filtre dans un convertisseur à deux branches, un fonctionnement équilibré des branches. De préférence, les enroulements 222_1 et 222_2 ont un même nombre N1 de tours, et les enroulements 224_1 et 224_2 ont un même nombre N2 de tours.

De préférence, chaque transformateur 220_1, 220_2, présente un couplage magnétique fort entre ses enroulements, par exemple chaque transformateur 220_1, 220_2 présente un coefficient de couplage supérieur à 0,9, de préférence supérieur à 0,95.

De tels transformateurs à fort couplage magnétique sont plus faciles à réaliser et à dimensionner que des transformateurs à couplage magnétique plus faible. En particulier, plus le couplage est fort, moins le transformateur est encombrant. De plus, les circuits magnétiques 226_1 et 226_2 peuvent avantageusement être des circuits magnétiques en forme de tore. En outre, les transformateurs à fort couplage magnétique présentent moins de fuites de champ magnétique que des transformateurs dont le couplage magnétique plus faible serait obtenu en prévoyant des fuites de champ magnétique. On réduit ainsi les émissions électromagnétiques parasites émises par le filtre. Egalement, la minimisation des fuites de champ magnétique va de pair avec une optimisation des pertes cuivre à haute fréquence, ce qui permet de faciliter le dimensionnement des transformateurs.

De préférence, le transformateur 220_1 a l'un de ses points de phase, ou point de repérage de sens d'enroulement, (point de phase 234_1 de l'enroulement 224_1 dans l'exemple représenté) situé du côté du transformateur 220_2, et l'autre de ses points de phase (point de phase 232_1 de l'enroulement 222_1 dans l'exemple représenté) situé du côté opposé au transformateur 220_2. De même, le transformateur 220_2 a l'un de ses points de phase, 232_2, situé du côté du transformateur 220_1, et l'autre de ses points de phase, 234_2, situé du côté opposé au transformateur 220_1. Ainsi, de préférence, les points de phase d'au moins deux enroulements d'une même voie sont opposés. Autrement dit, des courants circulant dans l'enroulement 222_1 en direction de l'enroulement 224_2, et dans l'enroulement 224_1 en direction de l'enroulement 222_2, provoquent des flux magnétiques de sens opposés dans le circuit magnétique 226_1. De même, des courants circulant dans les enroulements 224_2 et 222_2, se dirigeant vers les enroulements respectifs 222_1 et 224_1, provoquent des flux magnétiques de sens opposés dans le circuit magnétique 226_2. Ceci permet d'obtenir un sens de couplage magnétique optimisant la réduction des variations de courant dans les voies.

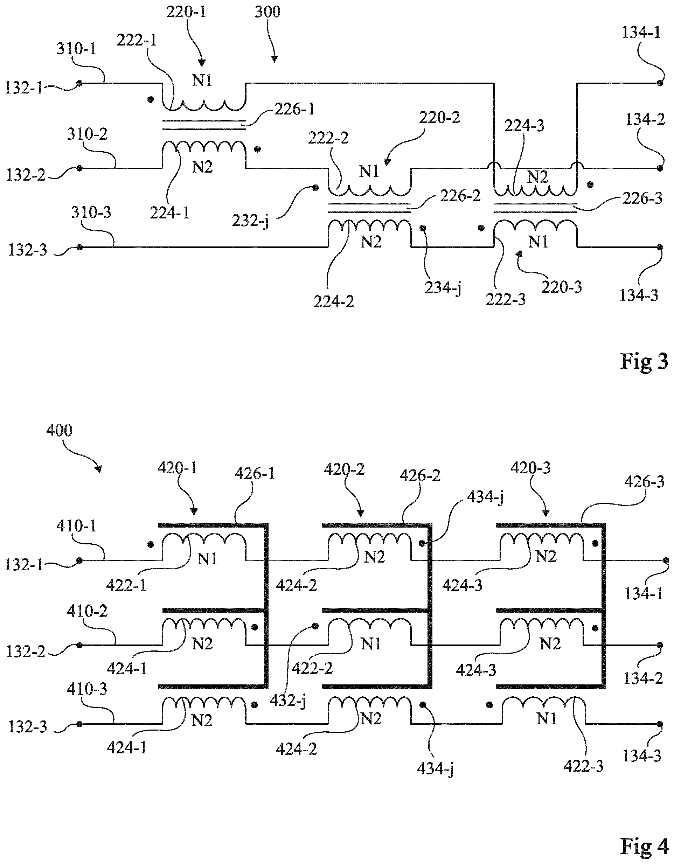

La figure 3 illustre de manière schématique un autre mode de réalisation d'un filtre inductif polyphasé 300.

Le filtre 300 comprend par exemple un nombre N de voies 310_i. Le nombre N de voies est par exemple le même que celui des branches d'un convertisseur dans lequel le filtre est destiné à être utilisé. Chaque voie 310_i relie un noeud 132_i à un noeud 134_i. A titre d'exemple, on a représenté le cas de trois voies 310_1, 310_2 et 310_3, reliant les noeuds respectifs 132_1, 132_2 et 132_3 aux noeuds respectifs 134_1, 134_2 et 134_3.

Le filtre 300 comprend des transformateurs 220_j, de préférence en nombre égal au nombre N des voies, l'indice j étant alors un entier compris entre 1 et N. Ainsi, le dispositif représenté comprend trois transformateurs 220_1, 220_2 et 220_3. Les transformateurs 220_j sont identiques ou similaires aux transformateurs 220_1 et 220_2 de la figure 2. En particulier, chaque transformateur comprend deux enroulements 222_j (222_1, 222_2 et 222_3) et 224_j (224_1, 224_2 et 224_3), et un circuit magnétique 226_j (226_1, 226_2 et 226_3) couplant magnétiquement entre eux les enroulements 222_j et 224_j. Chaque enroulement d'un transformateur est électriquement en série avec un enroulement d'un autre des transformateurs.

Les rapports de transformation des transformateurs 220_j sont différents de 1. De préférence, les transformateurs 220_j présentent, entre leurs enroulements respectifs 222_j et 224_j, des rapports de transformation identiques, par exemple de même valeur que celle des transformateurs 220_l et 220_2 de la figure 2.

Chaque voie 310_i comprend, électriquement en série, un enroulement 222_j d'un des transformateurs 220_j et un enroulement 224_j situés dans un autre des transformateurs 220_j. Autrement dit, le filtre 300 comporte, comme le filtre 200 de la figure 2, au moins deux voies dont chacune comporte au moins deux enroulements en série de transformateurs différents, c'est-à-dire distincts. Ainsi, chaque transformateur 220_j a ses enroulements situés dans des voies 310_i distinctes. Les transformateurs 220_j couplent donc magnétiquement les voies 310_i entre elles.

Comme dans le filtre 200 de la figure 2, du fait que les rapports de transformation sont différents de 1, le couplage magnétique optimum entre les voies est plus facile à obtenir que dans un filtre dans lequel les rapports de transformation seraient égaux à 1 et le couplage magnétique serait réglé par une configuration particulière des circuits magnétiques 226_j des transformateurs. Les rapports de transformation dans le filtre de la figure 3 peuvent alors être choisis de manière à optimiser le couplage magnétique entre les voies 310_i.

De préférence, pour chaque voie 310_i, l'enroulement situé dans le transformateur 220_j d'indice j le moins élevé est situé du côté du noeud 132_i. Pour chaque voie, l'enroulement situé dans le transformateur 220_j d'indice j le plus élevé est ainsi situé du côté du noeud 134_i. Autrement dit, l'indice j définit un ordre des transformateurs, et, dans chaque voie, les enroulements sont disposés dans l'ordre des transformateurs.

De préférence, chaque transformateur a un point de phase situé du côté des noeuds 132_i, et un point de phase situé du côté des noeuds 134_i. Par exemple, dans chaque voie 310_i, l'enroulement 222_j a son point de phase 232_j situé du côté du noeud 132_i, et l'enroulement 224_j a son point de phase 234_j situé du côté du noeud 134_i. Autrement dit, dans chaque transformateur 220_j, des courants circulant dans les enroulements 222_j et 224_j en direction des indices j croissants, provoquent des flux magnétiques de sens opposés dans le circuit magnétique 226_i.

L'ordre des enroulements le long des voies et les positions des points de phase permettent d'obtenir un sens de couplage magnétique qui optimise la réduction des variations de courant dans les voies.

La figure 4 représente schématiquement un autre mode de réalisation d'un filtre inductif polyphasé 400. Le filtre comprend un nombre N de voies 410_i reliant les noeuds 132_i respectivement aux noeuds 134_i. L'exemple représenté correspond au cas N=3. Ainsi, les voies 410_1, 410_2 et 410_3 relient les noeuds respectifs 132_1, 132_2, 132_3 aux noeuds respectifs 134_1, 134_2, 134_3.

Le filtre 400 comprend plusieurs transformateurs 420_j. De préférence, le nombre de transformateurs est égal au nombre N de voies. Chaque transformateur 420_j comprend un enroulement 422_j, et plusieurs enroulements 424_j. Le nombre M d'enroulements 424_j dans chaque transformateur est de préférence inférieur ou égal à N-1. L'exemple représenté correspond au cas M=2. Dans chaque transformateur, les enroulements sont couplés magnétiquement par les circuits magnétiques 426_j. Les circuits magnétiques 426_j sont représentés ici de manière symbolique, et ont par exemple des formes de tore. Chaque enroulement d'un transformateur est électriquement en série avec un enroulement d'un autre transformateur.

Chaque voie comprend une association électrique en série d'un enroulement 422_j et de M enroulements 424_j. Les enroulements de chaque voie 410_i sont situés dans des transformateurs 420_j distincts. Dans chaque transformateur 420_j, les enroulements du transformateur sont ainsi situés dans des voies 410_i distinctes. Ainsi, les transformateurs couplent magnétiquement les voies entre elles.

Chaque transformateur 420_j présente, entre son enroulement 422_j et ses enroulements 424_j, des rapports de transformation différents de 1. Ces rapports de transformation sont de préférence supérieurs à 2 ou inférieurs à 0,5, de préférence supérieurs à 3 ou inférieurs à 1/3, préférentiellement supérieurs à 5 ou inférieurs à 1/5. Comme dans les modes de réalisation décrits précédemment, ceci permet d'obtenir facilement le couplage magnétique optimum entre les voies 410_i. Pour un même niveau de performance, les rapports de transformation peuvent être différents de ceux définis ci-dessus pour les transformateurs 220_l et 220_2.

En particulier, on peut utiliser des transformateurs à couplage fort, qui, comme ceci a été mentionné précédemment, sont faciles à réaliser. De préférence, chaque transformateur 420_j présente, entre son enroulement 422_j et ses enroulements 424_j, des coefficients de couplage supérieurs à 0,9, de préférence supérieurs à 0,95.

De préférence, dans chaque transformateur, les rapports de transformation entre l'enroulement 422_j et les enroulements 424_j sont identiques. De préférence, ces rapports de transformation ont une valeur identique dans tous les transformateurs.

De préférence, pour chaque voie 410_i, l'enroulement situé dans chaque transformateur 420_j est d'autant plus proche du noeud 132_i que l'indice j est faible. Autrement dit, les enroulements sont situés dans chaque voie dans l'ordre des transformateurs défini par l'indice j.

De préférence, dans chaque voie 410_i, l'enroulement 422_j a son point de phase 432_j du côté du noeud 132_i, et les enroulements 424_j ont leurs points de phase 434_j du côté du noeud 134_i. En variante, dans chaque transformateur, le côté des points de phase des enroulements 424_j peut être échangé avec le côté du point de phase de l'enroulement 422_j . Ainsi, dans chaque transformateur 420_j, des courants circulant dans les enroulements 422_j et 424_j en direction des indices j croissants, provoquent des flux magnétiques de sens opposés dans le circuit magnétique 426_i.

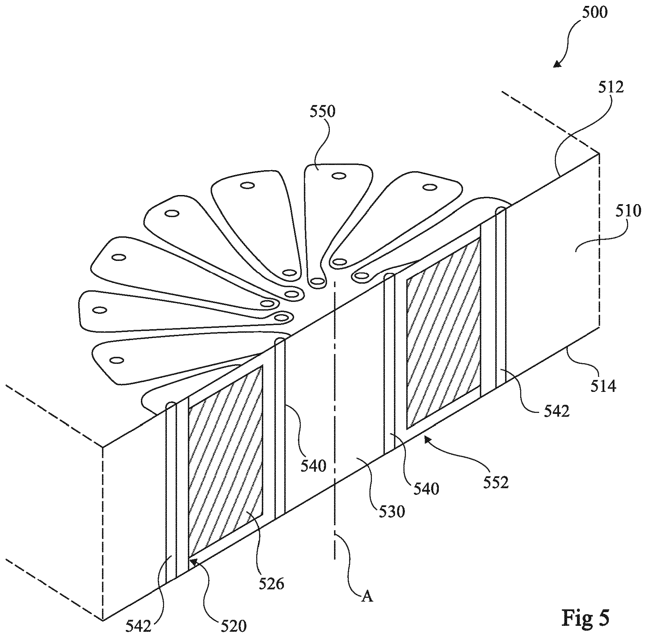

La figure 5 représente une vue schématique en coupe et en perspective d'un mode de réalisation d'un transformateur d'un filtre inductif. Plus précisément, le transformateur est intégré dans un circuit imprimé de type PCB 500 ("Printed Circuit Board") .

Le circuit imprimé comprend un substrat 510 en forme de plaque, électriquement isolante. Le substrat 510 comprend par exemple de la résine époxy et de la fibre de verre.

A titre d'exemple, pour réaliser le transformateur, on forme une ouverture 520 dans le substrat 510, de préférence circulaire. On positionne ensuite un circuit magnétique 526 en forme de tore dans l'ouverture 520. Le circuit est positionné dans l'épaisseur de la plaque et de sorte que l'axe A du tore (vertical sur la figure) est orthogonal aux faces principales 512, 514 de la plaque. De préférence, le circuit magnétique 526 comprend une poudre d'un matériau ferromagnétique tel que du fer ou de la ferrite.

On remplit ensuite la cavité d'un isolant 530, par exemple de la résine époxy. L'épaisseur du circuit magnétique est inférieure à celle de la plaque, de sorte que le circuit magnétique est isolé électriquement. Le circuit 526 se trouve ainsi inclus dans le substrat 510.

Les enroulements du transformateur sont formés ensuite, par exemple en même temps que des pistes de circuits électroniques non représentés. Les enroulements comprennent des vias 540 dans l'ouverture centrale du tore, et des vias 542 à l'extérieur du tore. Les vias 540 et 542 sont électriquement conducteurs et traversent le substrat verticalement de part en part. Les enroulements comprennent en outre des pistes 550 situées sur la face 512 et s'étendant, de manière sensiblement radiale par rapport à l'axe A, des vias 540 aux vias 542. De même, sur la face 514, des pistes 552 (non visibles) s'étendent, de manière sensiblement radiale par rapport à l'axe A, des vias 540 aux vias 542. Les pistes 550 et 552 sont reliées alternativement en série par les vias 540 et 542. Chaque association en série de plusieurs pistes 550 et 552 par plusieurs vias 540 et 542 constitue un enroulement.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art dans le cadre défini par la portée des revendications.

Enfin, la mise en oeuvre pratique des modes de réalisation et variantes décrits est à la portée de l'homme du métier à partir des indications fonctionnelles données ci-dessus.

## Revendications

1. Dispositif pour un convertisseur à découpage comprenant un filtre inductif polyphasé, comportant au moins deux transformateurs (220_j ; 420_j), dans lequel :
chaque enroulement (222_j, 224_j ; 422_j, 424_j) d'un transformateur est électriquement en série avec un enroulement d'un autre transformateur ; **caractérisé en ce que** au moins deux enroulements (222_j, 224_j ; 422_j, 424_j) d'un même transformateur ont des nombres de spires différents de sorte que les transformateurs ont un rapport de transformation différent de l'unité.

2. Dispositif selon la revendication 1, dans lequel le coefficient de couplage de chaque transformateur (220_j ; 420_j) est supérieur à 0,9.

3. Dispositif selon la revendication 1 ou 2, dans lequel les points de phase (232_j, 234_j) des enroulements (222_j, 224_j ; 422_j, 424_j) sont opposés.

4. Dispositif selon l'une quelconque des revendications 1 à 3, comportant au moins deux voies (210_1, 210_2 ; 310_i ; 410_i) dont chacune comporte au moins deux enroulements (222_j, 224_j ; 422_j, 424_j) en série de transformateurs (220_j ; 420_j) différents.

5. Dispositif selon la revendication 4, dans lequel les points de phase (232_j, 234_j) d'au moins deux enroulements (222_j, 224_j ; 422_j, 424_j) d'une même voie sont opposés.

6. Dispositif selon la revendication 4 ou 5, dans lequel le nombre de transformateurs (220_j ; 420_j) est égal au nombre de voies (210_1, 210_2 ; 310_i ; 410_i).

7. Dispositif selon l'une quelconque des revendications 4 à 6, dans lequel le nombre d'enroulements (222_j, 224_j ; 422_j, 424_j) en série par voie (210_1, 210_2 ; 310_i ; 410_i) est égal au nombre d'enroulements par transformateur (220_j ; 420_j).

8. Dispositif selon l'une quelconque des revendications 4 à 6, dans lequel chaque voie (210_1, 210_2 ; 310_i ; 410_i) représente une phase d'une tension alternative.

9. Dispositif selon l'une quelconque des revendications 1 à 8, dans lequel chaque transformateur (220_j ; 420_j) comprend un circuit magnétique (226_j ; 426_j ; 526) en forme de tore.

10. Dispositif selon l'une quelconque des revendications 1 à 9, comprenant un substrat (510) de type PCB dans lequel des circuits magnétiques (226_j ; 426_j ; 526) des transformateurs (220_j ; 420_j) sont inclus.

11. Dispositif selon la revendication 10, dans lequel lesdits enroulements (222_j, 224_j ; 422_j, 424_j) sont chacun défini par des pistes conductrices (550, 552) situées sur les faces opposées (512, 514) du substrat (510) et reliées en série par des vias (540, 542).

12. Filtre inductif polyphasé, comprenant un dispositif selon l'une quelconque des revendications 1 à 11.

13. Convertisseur à découpage, comprenant au moins un dispositif selon l'une quelconque des revendications 1 à 11.

## Patentansprüche

1. Eine Vorrichtung für ein Schalt- bzw. Switched-Mode-Konverter, der ein vielphasiges induktives Filter aufweist, das wenigstens zwei Transformatoren (220_j, 420_j) aufweist, wobei:
jede Windung (222_j, 224_j, 422_j, 424_j) eines Transformators elektrisch in Reihe geschaltet ist mit einer Windung eines anderen Transformators; und
**dadurch gekennzeichnet, dass** wenigstens zwei Windungen (222_j, 224_j, 422_j, 424_j) eines selben Transformators eine verschiedene Anzahl von Spiralen haben, so dass die Transformatoren ein Transformationsverhältnis verschieden von Eins haben.

2. Die Vorrichtung nach Anspruch 1, wobei der Kopplungskoeffizient jedes Transformators (220_j, 420_j) größer als 0,9 ist.

3. Die Vorrichtung nach einem der Ansprüche 1 oder 2, wobei die Phasenpunkte (232_j, 234_j) der Windungen (222_j, 224_j, 422_j, 424_j) entgegengesetzt sind.

4. Die Vorrichtung nach einem der Ansprüche 1 bis 3, die wenigstens zwei Pfade (210_1, 210_2; 310_i, 410_i) aufweist, von denen jeder wenigstens zwei Windungen (222_j, 224_j, 422_j, 424_j) aufweist, und zwar in Reihe von verschiedenen Transformatoren (220_j; 420_j).

5. Die Vorrichtung nach Anspruch 4, wobei die Phasenpunkte (232_j, 234_j) von wenigstens zwei Windungen (222_j, 224_j; 422_j, 424_j) eines selben Pfades entgegengesetzt sind.

6. Die Vorrichtung nach Anspruch 4 oder 5, wobei die Anzahl von Transformatoren (220_j; 420_j) gleich der Anzahl von Pfaden (210_1, 210_2; 310Ji, 410Ji) ist.

7. Die Vorrichtung nach einem der Ansprüche 4 bis 6, wobei die Anzahl von Windungen (222_j, 224_j; 422_j, 424_j) in Reihe pro Pfad (210_1, 210_2; 310_i, 410Ji) gleich ist zu der Anzahl von Windungen pro Transformator (220_j; 420_j).

8. Die Vorrichtung nach einem der Ansprüche 4 bis 6, wobei jeder Pfad (210_1, 210_2; 310_i, 410_i) eine Phase einer Wechselspannung darstellt.

9. Die Vorrichtung nach einem der Ansprüche 1 bis 8, wobei jeder Transformator (220_j; 420_j) eine toroidale magnetische Schaltung (226_j; 426_j; 526) aufweist.

10. Die Vorrichtung nach einem der Ansprüche 1 bis 9, die ein PCB-Typ-Substrat (510) aufweist, das magnetische Schaltungen (226_j; 426_j; 526) der Transformatoren (220_j; 420_j) darin beinhaltet.

11. Die Vorrichtung nach Anspruch 10, wobei die Windungen (222_j, 224_j; 422_j, 424_j) jeweils durch leitende Bahnen (550, 552) definiert werden, die auf den entgegenliegenden Oberflächen (512, 514) des Substrats (510) platziert sind und über Durchleitungen bzw. Vias (540, 542) in Reihe verbunden sind.

12. Ein vielphasiges induktives Filter, das die Vorrichtung nach einem der Ansprüche 1 bis 11 aufweist.

13. Ein Schalt- bzw. Switched-Mode-Konverter, der wenigstens eine Vorrichtung nach einem der Ansprüche 1 bis 11 aufweist.

## Claims

1. A device for a switched-mode converter comprising a polyphase inductive filter, comprising at least two transformers (220_j; 420_j), wherein:
each winding (222_j, 224_j; 422_j, 424_j) of a transformer is electrically in series with a winding of another transformer; and **characterized in that**
at least two windings (222_j, 224_j; 422_j, 424_j) of a same transformer have different numbers of spirals such that the transformers have a transformation ratio different from one.

2. The device of claim 1, wherein the coupling coefficient of each transformer (220_j; 420_j) is greater than 0.9.

3. The device of any of claim 1 or 2, wherein the phase points (232_j, 234_j) of the windings (222_j, 224_j; 422_j, 424_j) are opposite.

4. The device of any of claims 1 to 3, comprising at least two paths (210_1, 210_2; 310_i; 410_i), each of which comprises at least two windings (222_j, 224_j; 422_j, 424_j) in series of different transformers (220_j; 420_j).

5. The device of claim 4, wherein the phase points (232_j, 234_j) of at least two windings (222_j, 224_j; 422_j, 424_j) of a same path are opposite.

6. The device of claim 4 or 5, wherein the number of transformers (220_j; 420_j) is equal to the number of paths (210_1, 210_2; 310_i; 410_i).

7. The device of any of claims 4 to 6, wherein the number of windings (222_j, 224_j; 422_j, 424_j) in series per path (210_1, 210_2; 310_i; 410_i) is equal to the number of windings per transformer (220_j; 420_j).

8. The device of any of claims 4 to 6, wherein each path (210_1, 210_2; 310_i; 410_i) represents a phase of an AC voltage.

9. The device of any of claims 1 to 8, wherein each transformer (220_j; 420_j) comprises a toroidal magnetic circuit (226_j; 426_j; 526).

10. The device of any of claims 1 to 9, comprising a PCB-type substrate (510) having magnetic circuits (226_j; 426_j; 526) of the transformers (220_j; 420_j) included therein.

11. The device of claim 10, wherein said windings (222_j, 224_j; 422_j, 424_j) are each defined by conductive tracks (550, 552) located on the opposite surfaces (512, 514) of the substrate (510) and series-coupled by vias (540, 542).

12. A polyphase inductive filter comprising the device of any of claims 1 to 11.

13. A switched-mode converter comprising at least one device of any of claims 1 to 11.
